# EUROPEAN PATENT APPLICATION

(11) **EP 1 699 085 A2**
(43) Date of publication of application: **06.09.2006**
(21) Application number: 05254640.5
(22) Date of filing: 26.07.2005
(51) Int. Cl.: H01L 29/778, H01L 21/28

(54) **III-V nitride semiconductor device and production method thereof**

(30) Priority: 03.03.2005 JP 2005059380
(71) Applicant: FUJITSU LIMITED, Kawasaki-shi, Kanagawa 211-8588 (JP)
(72) Inventor: Kanamura, Masahito, c/o Fujitsu Limited, Kawasaki-shi Kanagawa 211-8588 (JP); Ohki, Toshihiro, c/o Fujitsu Limited, Kawasaki-shi Kanagawa 211-8588 (JP)
(74) Representative: Fenlon, Christine Lesley

(57) **Abstract**

A semiconductor device formed from a III-V nitride family semiconductor is disclosed that has a reduced gate leakage current and good interface characteristics between the III-V nitride family semiconductor and a gate insulating film. The semiconductor device includes a semiconductor layer (111, 112, 113, 114) formed from the III-V nitride family semiconductor, a gate insulating film (121) on the semiconductor layer, and a gate electrode (133) on the gate insulating film. The gate insulating film is formed from one of a tantalum oxide, a hafnium oxide, a hafnium aluminum oxide, a lanthanum oxide, and a yttrium oxide.

## Description

### CROSS-REFERENCE TO RELATED APPLICATION

This patent application is based on Japanese Priority Patent Application No. 2005-059380 filed on March 3, 2005, the entire contents of which are hereby incorporated by reference.

### BACKGROUND OF THE INVENTION

### 1. Field of the Invention

The present invention relates to a semiconductor device formed from a III-V nitride family semiconductor, such as a GaN-based semiconductor, and a method of producing the semiconductor device.

### 2. Description of the Related Art

In recent and continuing years, study and research are being actively performed on FETs (Field Effect Transistors) formed from GaN-based semiconductors. For example, reference can be made to Japanese Laid Open Patent Application No. 2002-359256 (referred to as "reference 1", below). The GaN-based semiconductors have features of large band-gaps, high breakdown electrical field strength, large saturation electron velocity, and other. For these reasons, it is expected that the FETs formed from GaN-based semiconductors will be applicable to devices requiring high output power and high voltage operations, for example, power devices used in base stations of cellular phones, which requires operation at 40 V or higher voltages. For example, a HEMT (High Electron Mobility Transistor) is a specific example of the FETs formed from GaN-based semiconductors, which includes a channel layer formed from GaN, and an electron supplying layer formed from AlGaN.

Reference 1 discloses an invention in which a SiN insulating film is arranged between a source electrode and a drain electrode in a FET formed from a GaN-based semiconductor.

Japanese Laid Open Patent Application No. 2001-185584 (referred to as "reference 2", below) and Japanese Laid Open Patent Application No. 54-36190 (referred to as "reference 3", below) disclose inventions of a Ta₂O₅ gate insulating film in a FET formed from a semiconductor.

In Applied Physics Letters, Vol. 77, pp. 1339 (2000) (referred to as "reference 4", below), Applied Physics Letters, Vol. 80, pp. 1661 (2002) (referred to as "reference 5", below), Applied Physics Letters, Vol. 73, pp. 3893 (1998) (referred to as "reference 6", below), and Electronics Letters, Vol. 34, pp. 592 (1998) (referred to as "reference 7", below), disclose inventions in which the gate insulating films of MISs (Metal / Insulating /Semiconductor) are formed from of specified materials.

In the FET formed from a GaN-based semiconductor, a Schottky electrode made from Ni or Pt is used as a gate electrode, and the height of the Schottky barrier at the interface between the Schottky electrode and the semiconductor layer is determined by the work function of the constituent metal of the Schottky electrode and the electron affinity of the semiconductor material of the semiconductor layer. For example, in the FET formed from a GaN-based semiconductor, the height of the Schottky barrier at the interface between the Schottky electrode and the semiconductor layer is approximately from 1 V to 1.2 V.

In order to apply the FETs formed from GaN-based semiconductors to devices requiring high output and high voltage operations, it is necessary to reduce the gate leakage current. However, with the height of the Schottky barrier being from 1 V to 1.2 V during operations at high input power and high voltages, a large gate leakage current is generated. In order to reduce the gate leakage current, it is preferable to interpose a gate insulating film between the gate electrode and the semiconductor layer so that the gate electrode and the semiconductor layer do not contact each other directly.

When reducing the gate leakage current, the constituent materials of the gate insulating film are important. In aforesaid reference 4, SiO₂ is used, in aforesaid reference 5, MgO and Sc₂O₃ are used, and in aforesaid reference 6, AlN is used.

However, in the related art, the gate leakage current is not sufficiently small, and the interface characteristics between the gate insulating film and the GaN semiconductor layer is not sufficiently good.

### SUMMARY OF THE INVENTION

It is a general object of the present invention to solve one or more of the problems of the related art.

It is a more specific object of the present invention to provide a semiconductor device formed from a III-V nitride family semiconductor that has a reduced gate leakage current and good interface characteristics between the III-V nitride family semiconductor and a gate insulating film of the semiconductor device.

According to a first aspect of the present invention, there is provided a semiconductor device formed from a III-V nitride family semiconductor, comprising: a semiconductor layer formed from the III-V nitride family semiconductor; a gate insulating film on the semiconductor layer; and a gate electrode on the gate insulating film, wherein the gate insulating film is formed from one of a tantalum oxide, a hafnium oxide, a hafnium aluminum oxide, a lanthanum oxide, and a yttrium oxide.

According to a second aspect of the present invention, there is provided a method of fabricating a semiconductor device formed from a III-V nitride family semiconductor, comprising the steps of: forming a semiconductor layer made from the III-V nitride family semiconductor; forming a gate insulating film on the semiconductor layer; and forming a gate electrode on the gate insulating film, wherein the gate insulating film is formed from one of a tantalum oxide, a hafnium oxide, a hafnium aluminum oxide, a lanthanum oxide, and a yttrium oxide.

According to the present invention, it is possible to provide a semiconductor device formed from a III-V nitride family semiconductor that has a reduced gate leakage current and a good interface between the III-V nitride family semiconductor and the gate insulating film.

These and other objects, features, and advantages of the present invention will become more apparent from the following detailed description of the preferred embodiments given with reference to the accompanying drawings.

### BRIEF DESCRIPTION OF THE DRAWINGS

FIG. 1 is a cross-sectional view illustrating a semiconductor device formed from a III-V nitride family semiconductor according to a first embodiment of the present invention;
FIG. 2A through 2E are cross-sectional views illustrating a method of fabricating the semiconductor device shown in FIG. 1;
FIG. 3 is a cross-sectional view illustrating a semiconductor device formed from a III-V nitride family semiconductor according to a second embodiment of the present invention;
FIG. 4A through 4E are cross-sectional views illustrating a method of fabricating the semiconductor device shown in FIG. 3;
FIG. 5 is a cross-sectional view illustrating a semiconductor device of the related art, illustrating problems in the related art;
FIG. 6 show measurement results of current-voltage characteristics of the FETs in the embodiments of the present invention;
FIG. 7 show measurement results of the gate characteristics of the FETs in the embodiments of the present invention;
FIG. 8 is a cross-sectional view illustrating a semiconductor device as a modification of the semiconductor device in FIG. 1;
FIG. 9 is a cross-sectional view illustrating a semiconductor device as a modification of the semiconductor device in FIG. 3;
FIG. 10 is a cross-sectional view illustrating a semiconductor device as another modification of the embodiments of the present invention;
FIG. 11 is a table presenting the specific dielectric constants and badgaps of the above materials; and
FIG. 12 shows the data in the table in a coordinate system.

### DESCRIPTION OF THE PREFERRED EMBODIMENTS

### First Embodiment

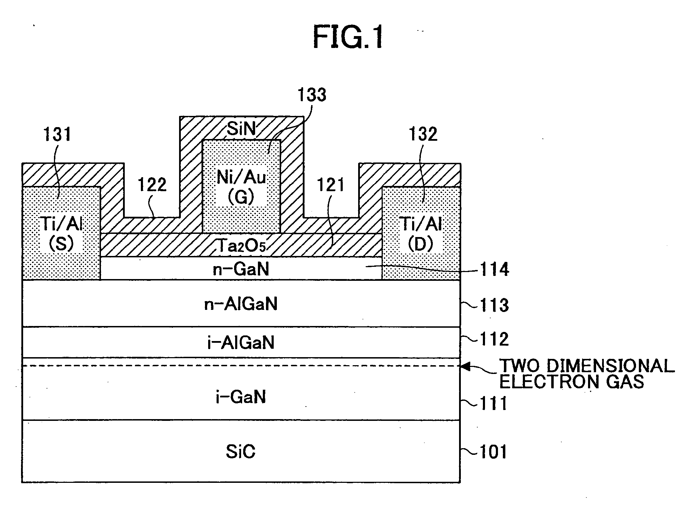

FIG. 1 is a cross-sectional view illustrating a semiconductor device formed from a III-V nitride family semiconductor according to a first embodiment of the present invention.

In the first embodiment, a HEMT (High Electron Mobility Transistor) is used as an example of a FET formed from the GaN-based semiconductor, and the HEMT includes a channel layer formed from GaN, and a carrier supplying layer formed from AlGaN.

The semiconductor device illustrated in FIG. 1 includes a substrate 101, semiconductor layers 111 through 114, a gate insulating film 121 formed on the semiconductor layers 111 through 114, an insulating film 122 formed on the surface of the gate insulating film 121, a source electrode 131, a drain electrode 132, and a gate electrode 133 formed on the gate insulating film 121. Near the surface of the semiconductor layer 111 there exists a two-dimensional electron gas.

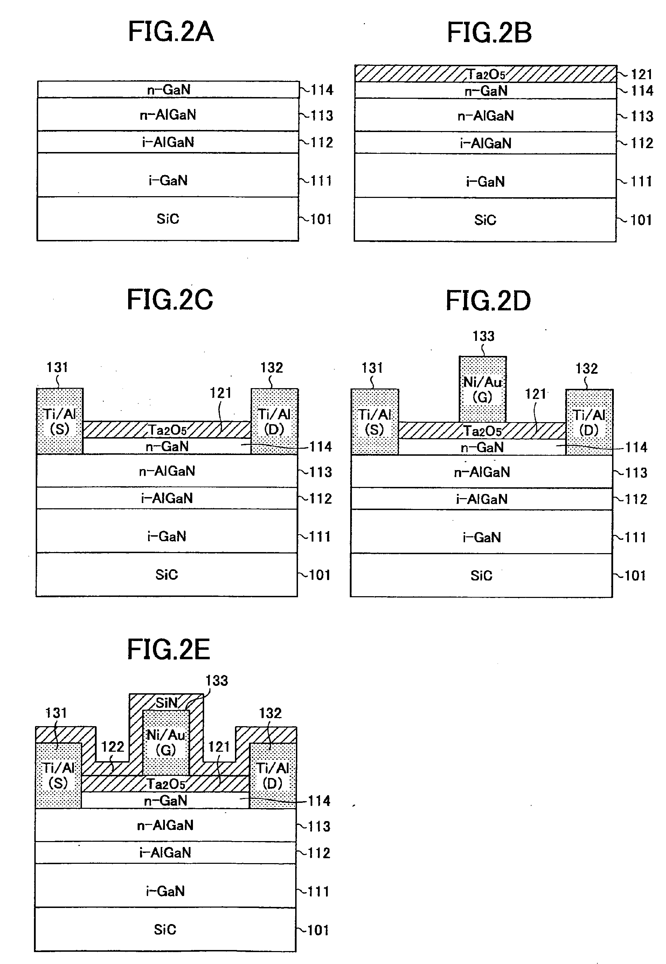

FIG. 2A through 2E are cross-sectional views illustrating a method of fabricating the semiconductor device shown in FIG. 1.

First as shown in FIG. 2A, on the substrate 101, for example, which is formed from SiC (sapphire), a channel layer 111 formed from i-type GaN is deposited to a thickness of 3 *µ*m. On the channel layer 111, a semiconductor layer 112 formed from i-type Al_{0.25}Ga_{0.75}N is deposited to a thickness of 3 nm. On the semiconductor layer 112, a carrier supplying layer 113 formed from n-type Al_{0.25}Ga_{0.75}N is deposited to a thickness of 20 nm and is doped with Si at a dose of 2 x 10¹⁸ cm⁻³. On the carrier supplying layer 113, a semiconductor layer 114 formed from n-type GaN is deposited to a thickness of 5 nm and is doped with Si at a dose of 2 x 10¹⁸ cm⁻³. For example, the channel layer 111, the semiconductor layer 112, the carrier supplying layer 113, and the semiconductor layer 114 are fabricated by MOVPE (Metal Organic Vapor Phase Epitaxy).

Next, as illustrated in FIG. 2B, on the surface of the semiconductor layer 114, the gate insulating film 121 formed from Ta₂O₅ is deposited to a thickness of 5 nm. For example, the gate insulating film 121 is formed by sputtering.

Next, on the surface of the gate insulating film 121, a photo resist coating is applied. After that, openings are formed in the photo resist at positions where the source electrode 131 and the drain electrode 132 (ohmic electrodes) are to be formed. Next, by wet etching with a hydrofluoric acid (HF), openings are formed in the gate insulating film 121 at positions where the source electrode 131 and the drain electrode 132 are to be formed. Next, by dry etching with a chlorine gas (Cl₂), openings are formed in the semiconductor layer 114 at positions where the source electrode 131 and the drain electrode 132 are to be formed.

Next, as illustrated in FIG. 2C, on the carrier supplying layer 113, by lift-off, the source electrode 131 and the drain electrode 132 each including a titanium portion and an aluminum portion are formed. Afterward, these electrodes are annealed at 550 °C.

Then, on the surface of the gate insulating film 121, a photo resist coating is applied. Then, by photolithography, an opening having a width of 1 *µ*m is formed in the photo resist at a position where the gate electrode (Schottky electrode) 133 is to be formed.

Next, as illustrated in FIG. 2D, on the gate insulating film 121, by lift-off, the gate electrode 133 is formed which includes a Ni portion having a thickness of 30 nm and a width of 1 *µ*m, and a Au portion having a thickness of 300 nm and a width of 1 *µ*m.

Next, as illustrated in FIG. 2E, on the surface of the gate insulating film 121, the insulating film 122 formed from SiN is deposited to a thickness of 10 nm. For example, the insulating film 122 is deposited by CVD (Chemical Vapor Deposition).

### Second Embodiment

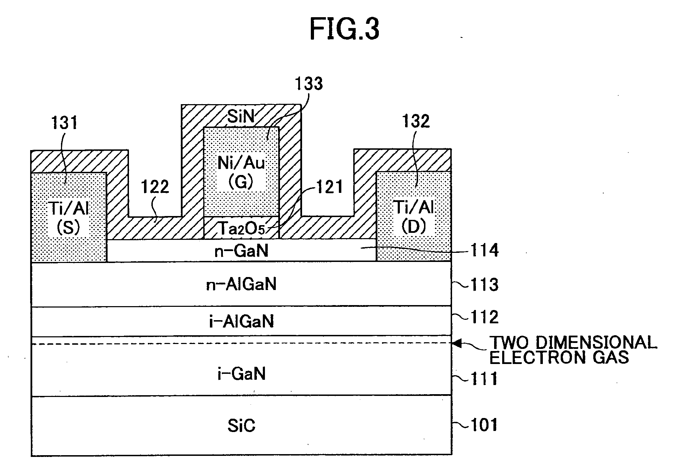

FIG. 3 is a cross-sectional view illustrating a semiconductor device formed from a III-V nitride family semiconductor according to a second embodiment of the present invention.

In the second embodiment, a HEMT (High Electron Mobility Transistor) is used as an example of a FET formed from the GaN-based semiconductor, and the HEMT includes a channel layer formed from GaN, and a carrier supplying layer formed from AlGaN.

The semiconductor device illustrated in FIG. 3 includes a substrate 101, semiconductor layers 111 through 114, a gate insulating film 121 formed on the semiconductor layers 111 through 114, an insulating film 122 formed on the surface of the gate insulating film 121, a source electrode 131, a drain electrode 132, and a gate electrode 133 formed on the gate insulating film 121.

The semiconductor device of the second embodiment is different from that of the first embodiment in that the gate insulating film 121 only partially covers the surface of the semiconductor layer 114, while in the first embodiment, the gate insulating film 121 covers the whole surface of the semiconductor layer 114.

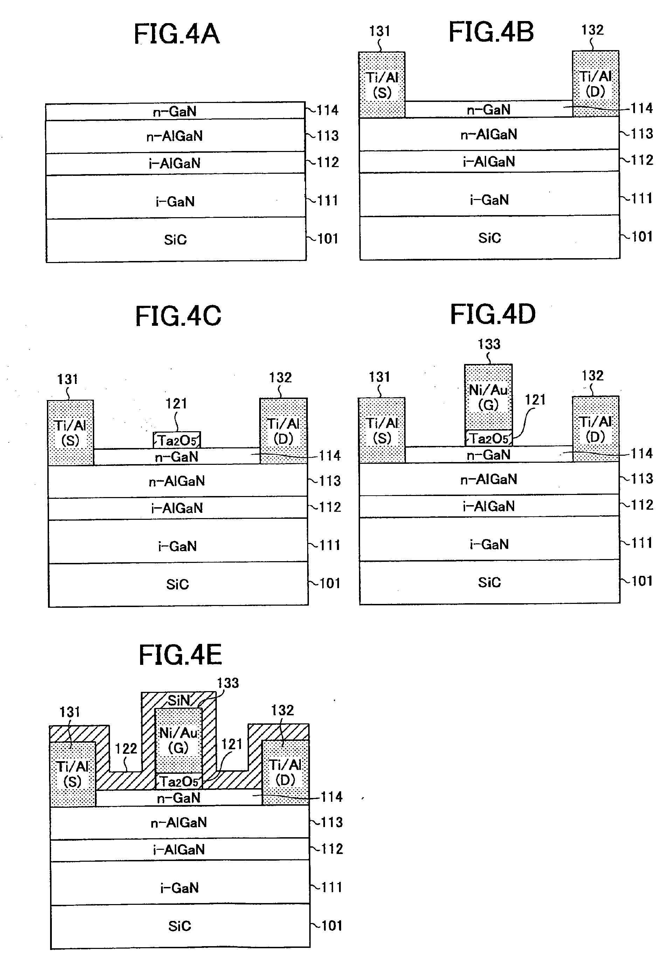

FIG. 4A through 4E are cross-sectional views illustrating a method of fabricating the semiconductor device shown in FIG. 3.

First, as shown in FIG. 4A, a channel layer 111, semiconductor layer 112, a carrier supplying layer 113, and a semiconductor layer 114 are deposited on the substrate 101.

Next, on the surface of the semiconductor layer 114, a photo resist coating is applied. After that, by photolithography, openings are formed in the photo resist at positions where the source electrode 131 and the drain electrode 132 are to be formed.

Next, by dry etching with a chlorine gas (Cl₂), openings are formed in the semiconductor layer 114 at positions where the source electrode 131 and the drain electrode 132 are to be formed.

Next, as illustrated in FIG. 4B, on the carrier supplying layer 113, by lift-off, the source electrode 131 and the drain electrode 132 each including a titanium portion and an aluminum portion are formed. Afterward, these electrodes are annealed at 550 °C.

Next, on the surface of the semiconductor layer 114, a photo resist coating is applied. Then, by photolithography, an opening having a width of 1 *µ*m is formed in the photo resist at a position where the gate electrode 133 is to be formed.

Next, as illustrated in FIG. 4C, on the surface of the semiconductor layer 114, the gate insulating film 121 formed from Ta₂O₅ is deposited to a thickness of 10 nm and having a width of 1 *µ*m. For example, the gate insulating film 121 is formed by sputtering.

Next, as illustrated in FIG. 4D, on the gate insulating film 121, by lift-off, the gate electrode 133 is formed which includes a Ni portion having a thickness of 30 nm and a width of 1 *µ*m, and a Au portion having a thickness of 300 nm and a width of 1 *µ*m.

Next, as illustrated in FIG. 4E, on the surface of the semiconductor layer 114, the insulating film 122 made of SiN is deposited to a thickness of 10 nm in contact with the gate insulating film 121. For example, the insulating film 122 is deposited by CVD (Chemical Vapor Deposition). In the first embodiment and the second embodiment, Ta₂O₅ is adopted to fabricate the gate insulating film 121 of the MIS (Metal / Insulating /Semiconductor), which is formed from the GaN-based semiconductor.

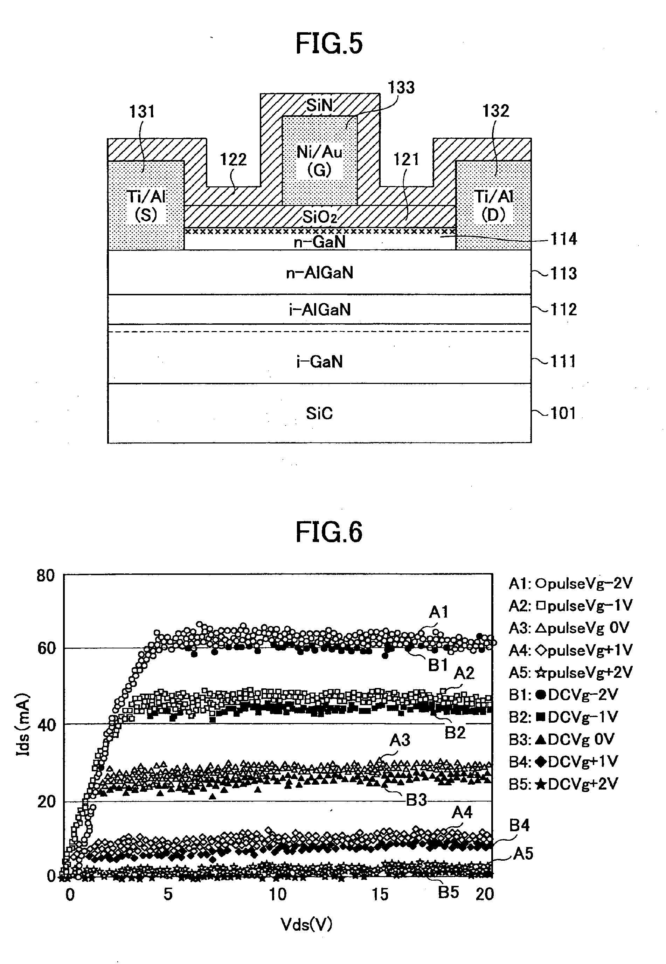

In comparison, FIG. 5 is a cross-sectional view illustrating a semiconductor device of the related art, illustrating problems in the related art.

When fabricating the MIS formed from the GaN-based semiconductor, if SiO₂ is used to form the gate insulating film 121 of the MIS, as shown in FIG. 5, adverse influences may be imposed on the interface between the gate insulating film 121 and the GaN semiconductor layer 114, thereby, increasing the resistance in an ON state of the MIS during high output and high voltage operations.

In addition, SiO₂ has a relatively small specific dielectric constant, which is only about 3.8, it is not suitable for the gate insulating film 121 in the GaN semiconductor MIS.

In the present invention, as a result of studies by the inventors of the present invention, it was found that when fabricating the MIS formed from the GaN-based semiconductor, if Ta₂O₅ is used as the gate insulating film 121 of the MIS, as shown in FIG. 1 and FIG. 2, there is little adverse influence on the interface between the gate insulating film and the GaN semiconductor layer.

Consequently, with the Ta₂O₅ gate insulating film 121 in the MIS formed from the GaN-based semiconductor in the first embodiment or the second embodiment, it is possible to reduce influences on the interface between the gate insulating film and the GaN semiconductor layer, and reduce the gate leakage current. Further, compared to a small specific dielectric constant of SiO₂, which is only about 3.8, the specific dielectric constant of Ta₂O₅ is about 25. Because of the large specific dielectric constant of Ta₂O₅, the effective thickness of a Ta₂O₅ film can be increased easily, and this results in large the insulating breakdown electrical field strength, namely, Ta₂O₅ is suitable for the gate insulating film 121 in the GaN semiconductor MIS.

In the first embodiment and the second embodiment, as an example of a FET formed from the GaN-based semiconductor, the HEMT (High Electron Mobility Transistor) is fabricated to include a channel layer formed from GaN, and a carrier supplying layer formed from AlGaN.

As described above, it is expected that the FETs formed from GaN-based semiconductors will be applicable to devices requiring high output and high voltage operations, and the HEMT is a FET able to meet the requirements. Consequently, with the FET formed from the GaN-based semiconductor being the HEMT, both the constituent materials (GaN-based semiconductor) and the FET structure (HEMT) are suitable for fabricating a FET capable of high output and high voltage operations.

Further, as revealed by the inventors of the present invention, with the GaN-based semiconductor as the semiconductor material, and the gate insulating film 121 being made from the Ta₂O₅, there is little adverse influence on the interface between the gate insulating film and the GaN semiconductor layer.

FIG. 6 show measurement results of current-voltage characteristics of the FETs in the embodiments of the present invention. In FIG. 6, the abscissa indicates a drain voltage, and the ordinate indicates a drain current. In addition, in FIG. 6, symbols "A1", "A2", "A3", "A4" and "A5" indicate measurement results of current-voltage characteristics at -2V, -1V, OV, +1V, +2V, respectively, with the gate voltage being a pulsed voltage, and symbols "B1", "B2", "B3", "B4" and "B5" indicate measurement results of current-voltage characteristics at -2V, -1V, 0V, +1V, +2V, respectively, with the gate voltage being a DC voltage.

As illustrated in FIG. 6, the results when the gate voltage is a pulsed voltage (below, referred to as "pulse characteristics") and the results when the gate voltage is a DC voltage (below, referred to as "DC characteristics") overlap with each other. This reveals that the FETs of the present embodiments are able to quickly respond to pulses, and trap at levels at the interface between the Ta₂O₅ gate insulating film and the GaN semiconductor layer 14 is not significant. Namely, Ta₂O₅ is suitable for the gate insulating film 121 in the GaN semiconductor FET.

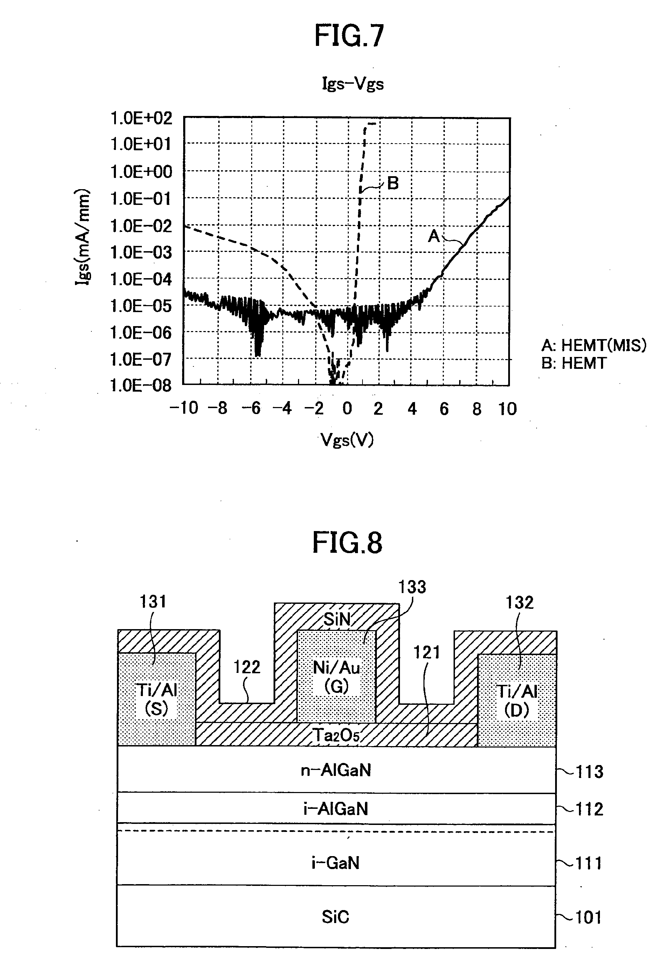

FIG. 7 show measurement results of the gate characteristics of the FETs in the embodiments of the present invention. In FIG. 7, the abscissa indicates a gate voltage, and the ordinate indicates a gate current. In addition, in FIG. 7, a symbol "A" indicates measurement results of the FETs in the embodiments of the present invention (that is, with the gate insulating film 121 made from Ta₂O₅), and a symbol "B" indicates measurement results of a FET without the gate insulating film 121 for comparison.

As shown by the measurement results "A", the gate leakage current is small even at +10 V; in contrast, as shown by the measurement results "B", the gate leakage current is large even at +1 V. In other words, In the FETs of the embodiments of the present invention, the gate leakage current is greatly reduced.

The semiconductor device of the second embodiment differs from that of the first embodiment in that the insulating film on the semiconductor layer 114 include a portion of the Ta₂O₅ gate insulating film 121 and a portion of the SiN insulating film 122. In other words, the Ta₂O₅ gate insulating film 121 only partially covers the surface of the semiconductor layer 114; while in the first embodiment, the Ta₂O₅ gate insulating film 121 covers the whole semiconductor layer 114 between the source electrode 131 and the drain electrode 132. The structure in the first embodiment is simple and can be fabricated easily.

In the first embodiment and the second embodiment, the semiconductor layer 114, which is made from Al_{0.25}Ga_{0.75}N, is arranged on the carrier supplying layer 113, which is made from GaN. The semiconductor layer 114 functions as a protection layer of the carrier supplying layer 113 to prevent oxidation of aluminum in the carrier supplying layer 113.

It should be noted that although in FIG. 1, FIG. 2A through FIG. 2E, FIG. 3, and FIG. 4A through FIG. 4E, the semiconductor layer 114 is arranged on the carrier supplying layer 113, it is not required to arrange the semiconductor layer 114 on the carrier supplying layer 113, and the semiconductor layer 114 may be omitted.

FIG. 8 is a cross-sectional view illustrating a semiconductor device as a modification of the semiconductor device in FIG. 1.

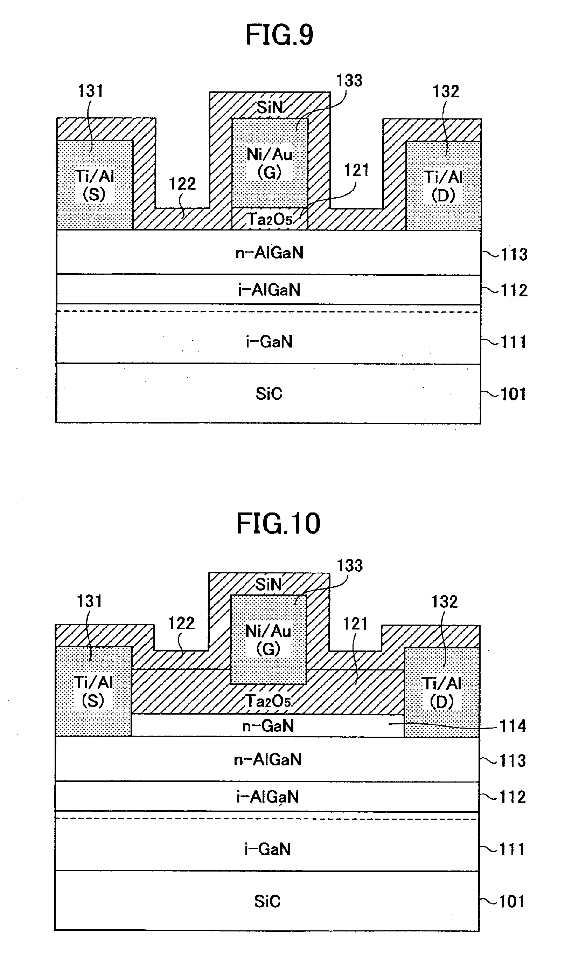

FIG. 9 is a cross-sectional view illustrating a semiconductor device as a modification of the semiconductor device in FIG. 3.

As illustrated in FIG. 8 and FIG. 9, there is no semiconductor layer 114 on the carrier supplying layer 113.

When fabricating the semiconductor device shown in FIG. 8 or FIG. 9, it is just needed to omit the step of depositing the semiconductor layer 114 on the carrier supplying layer 113 as in shown in FIG. 2A through 2E or FIG. 4A through 4E, respectively.

However, it is preferable to form the semiconductor layer 114 on the carrier supplying layer 113 from the view of protecting the carrier supplying layer 113. Further, from the view of good interface characteristics, it is preferable to make the Ta₂O₅ layer 121 be in direct contact with the GaN layer 114 rather than to make the Ta₂O₅ layer 121 be in direct contact with the Al_{0.25}Ga_{0.75}N layer 113.

FIG. 10 is a cross-sectional view illustrating a semiconductor device as another modification of the embodiments of the present invention.

As illustrated in FIG. 10, the gate electrode 133 is disposed in a recess of the gate insulating film 121. Because of such a structure, it is possible to prevent concentration of the electric field in the gate insulating film 121, which is positioned right below the gate electrode 133. For example, the thickness of the gate insulating film 121 is 10 nm within the area of the recess, and is 100 nm outside of the area of the recess.

When fabricating the semiconductor device shown in FIG. 10, for example, it is sufficient to add a step of etching the gate insulating film 121 to form the recess immediate before depositing the gate electrode 133 in the fabricating process in FIG. 2A through FIG. 2E. In addition, it is not required that the Ta₂O₅ gate insulating film 121 cover the whole region between the source electrode 131 and the drain electrode 132.

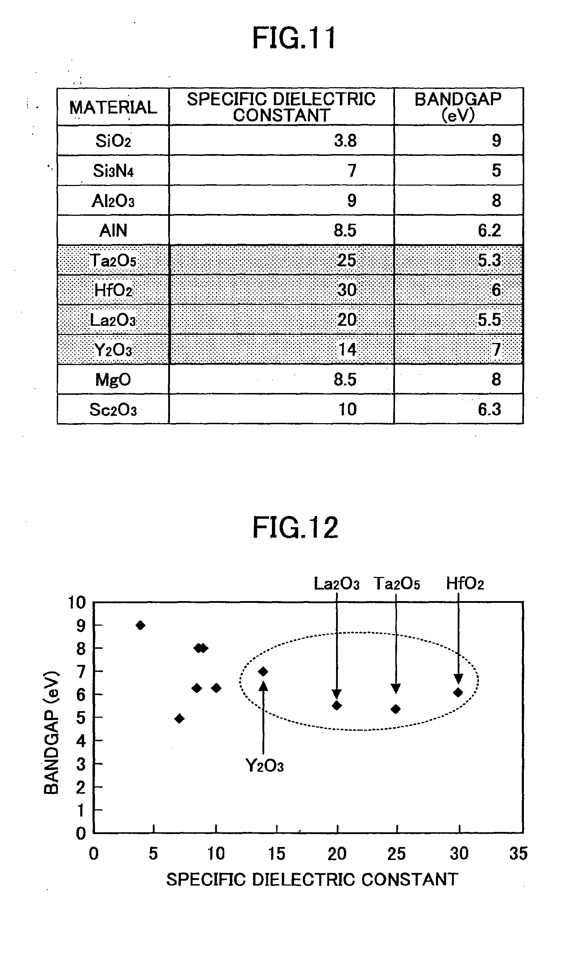

In the above embodiments, it is described that Ta₂O₅ is adopted to fabricate the gate insulating film 121 of the FET formed from the GaN-based semiconductor. However, the material of the gate insulating film 121 is not limited to Ta₂O₅, but the gate insulating film 121 can be formed from a hafnium oxide (for example, HfO₂), a hafnium aluminum oxide (for example, HfₓAl₁₋ₓO, where 0<x<1), a lanthanum oxide(for example, La₂O₃), and a yttrium oxide (for example, Y₂O₃). FIG. 11 and FIG. 12 present properties of these materials.

FIG. 11 is a table presenting the specific dielectric constants and badgaps of the above materials.

FIG. 12 shows the data in the table in a coordinate system.

As illustrated in FIG. 11 and FIG. 12, the specific dielectric constants of HfO₂, HfₓAl₁₋ₓO, La₂O₃, and Y₂O₃ are all over 10, and the badgaps of them are all over 5 eV. Thus, these materials are suitable to be materials of the gate insulating film 121 in the GaN semiconductor FET.

While the invention is described above with reference to specific embodiments chosen for purpose of illustration, it should be apparent that the invention is not limited to these embodiments, but numerous modifications could be made thereto by those skilled in the art without departing from the basic concept and scope of the invention.

For example, the FET formed from the GaN-based semiconductor is not limited to a HEMT (High Electron Mobility Transistor), but can be MESFER, or HET, or RHET. In addition, in the present invention, the III-V nitride family semiconductor is not limited to a GaN-based semiconductor, but can be others.

## Claims

1. A semiconductor device formed from a III-V nitride family semiconductor, comprising:
a semiconductor layer formed from the III-V nitride family semiconductor;
a gate insulating film on the semiconductor layer; and
a gate electrode on the gate insulating film;
wherein the gate insulating film is formed from one of a tantalum oxide, a hafnium oxide, a hafnium aluminum oxide, a lanthanum oxide, and a yttrium oxide.

2. The semiconductor device as claimed in claim 1, wherein
the semiconductor layer comprises:
a channel layer in which carriers travel;
a carrier supplying layer that supplies carriers; and
a protection layer that protects the carrier supplying layer, and
the gate insulating film that is formed on the protection layer.

3. The semiconductor device as claimed in claim 1, wherein
the semiconductor layer comprises:
a channel layer in which carriers travel;
a carrier supplying layer that supplies carriers; and
the gate insulating film that is formed on the carrier supplying layer.

4. The semiconductor device as claimed in claim 2, wherein
the channel layer includes a semiconductor layer formed from GaN,
the carrier supplying layer includes a semiconductor layer formed from AIGaN, and
the protection layer includes a semiconductor layer formed from GaN.

5. The semiconductor device as claimed in claim 3, wherein
the channel layer includes a semiconductor layer formed from GaN, and
the carrier supplying layer includes a semiconductor layer formed from AlGaN.

6. The semiconductor device as claimed in claim 1, wherein an insulating film formed from a material different from the gate insulating film is disposed on the semiconductor layer.

7. The semiconductor device as claimed in claim 1, wherein the gate electrode is disposed in a recess of the gate insulating film.

8. A method of fabricating a semiconductor device formed from a III-V nitride family semiconductor, comprising the steps of:
forming a semiconductor layer made from the III-V nitride family semiconductor;
forming a gate insulating film on the semiconductor layer; and
forming a gate electrode on the gate insulating film;
wherein the gate insulating film is formed from one of a tantalum oxide, a hafnium oxide, a hafnium aluminum oxide, a lanthanum oxide, and a yttrium oxide.

9. The method as claimed in claim 8, wherein
the step of forming the semiconductor layer includes steps of:
forming a channel layer in which carriers travel;
forming a carrier supplying layer for supplying the carriers; and
forming a protection layer for protecting the carrier supplying layer; wherein
the gate insulating film is formed on the protection layer.

10. The method as claimed in claim 8, wherein
the step of forming the semiconductor layer includes steps of:
forming a channel layer in which carriers travel; and
forming a carrier supplying layer that supplies carriers; wherein
the gate insulating film is formed on the carrier supplying layer.

11. The method as claimed in claim 9, wherein
the channel layer includes a semiconductor layer formed from GaN,
the carrier supplying layer includes a semiconductor layer formed from AlGaN, and
the protection layer includes a semiconductor layer formed from GaN.

12. The method as claimed in claim 10,
wherein
the channel layer includes a semiconductor layer formed from GaN, and
the carrier supplying layer includes a semiconductor layer formed from AlGaN.

13. The method as claimed in claim 8,
wherein an insulating film formed from a material different from the gate insulating film is disposed on the semiconductor layer.

14. The method as claimed in claim 8,
wherein the gate electrode is disposed in a recess of the gate insulating film.
